(19) Europäisches Patentamt
European Patent Office
Office européen des brevets

(11) **EP 4 523 956 A1**

(12) **EUROPEAN PATENT APPLICATION**

(43) Date of publication:
**19.03.2025 Bulletin 2025/12**

(21) Application number: **24164760.1**

(22) Date of filing: **20.03.2024**

(51) International Patent Classification (IPC):
***B60L 58/12*** (2019.01) ***G01R 31/367*** (2019.01)
***G01R 31/3835*** (2019.01) ***G01R 31/3842*** (2019.01)
***G01R 31/396*** (2019.01) ***H01M 10/48*** (2006.01)
***H02J 7/00*** (2006.01)

(52) Cooperative Patent Classification (CPC):
**H01M 10/48; B60L 58/12; G01R 31/367; G01R 31/3835; G01R 31/3842; G01R 31/396; H01M 10/482; H02J 7/0048**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **13.09.2023 KR 20230121796**

(71) Applicant: **Samsung SDI Co., Ltd.**
**Yongin-si, Gyeonggi-do 17084 (KR)**

(72) Inventor: **HA, Sang Min**
**16678 Suwon-si (KR)**

(74) Representative: **Marks & Clerk LLP**
**15 Fetter Lane**
**London EC4A 1BW (GB)**

(54) **APPARATUS AND METHOD FOR ESTIMATION OF BATTERY STATE-OF-CHARGE**

(57) A battery state-of-charge estimation apparatus includes: a memory, and a processor connected to the memory. Upon charging/discharging of a battery rack including multiple battery cells, the processor calculates a maximum SOC of a maximum-voltage cell and a minimum SOC of a minimum-voltage cell and calculates a representative SOC of the battery rack based on the maximum SOC and the minimum SOC. A corresponding battery state-of-charge estimation method is also disclosed.

FIG. 3

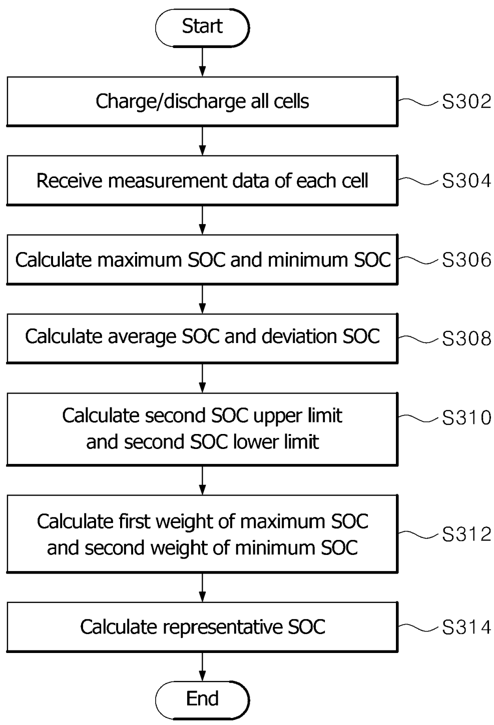




Processed by Luminess, 75001 PARIS (FR)

## Description

## BACKGROUND

### 1. Field

The present disclosure relate to an apparatus and method for estimation of battery state-of-charge.

### 2. Description of the Related Art

As environmental destruction and resource depletion become serious issues, there is growing interest in energy storage systems (ESS) that can store energy and efficiently utilize the stored energy. An ESS includes dozens to hundreds of cells connected in series or parallel to form a battery rack.

As a method of controlling charging/discharging of multiple cells constituting such a battery rack, an average SOC (stage of charge) of the multiple cells in the battery rack is calculated to perform charging/discharging of the cells based on the calculated average of SOC.

However, there is a problem of deviation in states of charge of the cells when the state of charge of each cell is determined based on the average SOC of the multiple cells in the battery rack upon charging/discharging the cells.

In addition, if the SOC is calculated from an average voltage of all cells, there is a risk of overcharging at the time of full charge and overdischarging at the time of full discharge due to an error from an available capacity of an actual battery rack. Specifically, since cells having a higher SOC than an average SOC can be charged (overcharged) more than necessary and cells having a lower SOC than the average SOC can be discharged (overdischarged) more than necessary, some cells continue to charge/discharge intermittently at upper and lower limits of the depth of discharge (DOD). This phenomenon acts a major factor of cell degeneration and results in degradation in battery performance.

The background technique of the present invention is disclosed in Korean Patent Registration No. 10-1467363.

## SUMMARY

Aspects of the present invention include an apparatus and method for estimation of battery state-of-charge for protecting batteries from overcharging/overdischarging in a battery rack including multiple cells.

In accordance with one aspect of the present invention, a battery state-of-charge estimation apparatus includes: a memory; and a processor connected to the memory, wherein, upon charging/discharging a battery rack comprising multiple battery cells, the processor calculates a maximum state of charge (SOC) of a maximum-voltage cell and a minimum SOC of a minimum-voltage cell and calculates a representative SOC of the battery rack based on the maximum SOC and the minimum SOC.

In some embodiments, upon charging/discharging the battery rack, the processor may calculate the maximum SOC based on a voltage and current of the maximum-voltage cell having a highest voltage among voltages of the multiple battery cells, and may calculate the minimum SOC based on a voltage and current of the minimum-voltage cell having a lowest voltage among the voltages of the multiple battery cells.

In some embodiments, the processor may calculate a first weight of the maximum SOC and a second weight of the minimum SOC based on a battery operation range, an average SOC and a deviation SOC of the maximum SOC and the minimum SOC, and may apply the first weight and the second weight to the maximum SOC and the minimum SOC, respectively, to calculate the representative SOC.

In some embodiments, the processor may apply the deviation SOC to a first SOC upper limit and a first SOC lower limit corresponding to the battery operation range to calculate a second SOC upper limit and a second SOC lower limit, and may calculate the first weight of the maximum SOC and the second weight of the minimum SOC based on the second SOC upper limit, the second SOC lower limit, and the average SOC.

In some embodiments, the processor may subtract a preset ratio of the deviation SOC from the first SOC upper limit to calculate the second SOC upper limit and may add the preset ratio of the deviation SOC to the first SOC lower limit to calculate the second SOC lower limit.

In some embodiments, the processor may calculate the second weight by dividing a value obtained through subtraction of the average SOC from the second SOC upper limit by a value obtained through subtraction of the second SOC lower limit from the second SOC upper limit and may calculate the first weight by subtracting the second weight from 1.

In accordance with another aspect of the present invention, a battery state-of-charge estimation method includes, upon charging/discharging a battery rack comprising multiple battery cells: receiving, by a processor, measurement data of each of the battery cells from a sensor; calculating, by the processor, a maximum SOC of a maximum-voltage cell and a minimum SOC of a minimum-voltage cell based on the measurement data of each of the battery cells; and

calculating, by the processor, a representative SOC of the battery rack based on the maximum SOC and the minimum SOC.

In some embodiments, in calculating the maximum SOC of the maximum-voltage cell and the minimum SOC of the minimum-voltage cell, the processor may calculate the maximum SOC based on a voltage and a current of the maximum-voltage cell having a highest voltage among voltages of the multiple battery cells, and may calculate the minimum SOC based on a voltage and a current of the minimum-voltage cell having a lowest voltage among the voltages of the multiple battery cells.

In some embodiments, the step of calculating a representative SOC of the battery rack may include: calculating, by the processor, an average SOC and a deviation SOC of the maximum SOC and the minimum SOC; applying, by the processor, the deviation SOC to a first SOC upper limit and a first SOC lower limit corresponding to a battery operating range to calculate a second SOC upper limit and a second SOC lower limit; calculating, by the processor, a first weight of the maximum SOC and a second weight of the minimum SOC based on the second SOC upper limit, the second SOC lower limit, and the average SOC; and applying, by the processor, the first weight and the second weight to the maximum SOC and the minimum SOC, respectively, to calculate the representative SOC of the battery rack.

In some embodiments, in calculating the second SOC lower limit, the processor may subtract a preset ratio of the deviation SOC from the first SOC upper limit to calculate the second SOC upper limit and may add the preset ratio of the deviation SOC to the first SOC lower limit to calculate the second SOC lower limit.

In some embodiments, in calculating the second weight, the processor may calculate the second weight by dividing a value obtained through subtraction of the average SOC from the second SOC upper limit by a value obtained through subtraction of the second SOC lower limit from the second SOC upper limit and may calculate the first weight by subtracting the second weight from 1.

A battery state-of-charge estimation apparatus and method according to the present invention calculates a representative SOC of a battery rack based on a maximum SOC of a maximum-voltage cell and a minimum SOC of a minimum-voltage cell upon charging/discharging a battery rack including multiple cells, thereby providing an effect of protecting batteries from overcharging/overdischarging while enabling calculation of the SOC with minimal resources.

At least some of the above and other features of the invention are set out in the claims.

## Brief Description of Drawings

The following drawings attached to this specification illustrate embodiments of the present disclosure, and further describe aspects and features of the present disclosure together with the detailed description of the present disclosure. Thus, the present disclosure should not be construed as being limited to the drawings:

FIG. 1 is a schematic block diagram of a battery state-of-charge estimation system according to one embodiment of the present invention.

FIG. 2 is a schematic block diagram of a battery state-of-charge estimation apparatus according to one embodiment of the present invention.

FIG. 3 is a flow diagram illustrating a method for calculating a representative SOC of a battery rack according to one embodiment of the present invention.

FIG. 4 is a graph comparing the representative SOC calculation method according to the embodiment of the invention with a typical SOC calculation method.

## Detailed Description

Hereinafter, embodiments of the present disclosure will be described, in detail, with reference to the accompanying drawings. The terms or words used in this specification and claims should not be construed as being limited to the usual or dictionary meaning and should be interpreted as meaning and concept consistent with the technical idea of the present disclosure based on the principle that the inventor can be his/her own lexicographer to appropriately define the concept of the term to explain his/her invention in the best way.

The embodiments described in this specification and the configurations shown in the drawings are only some of the embodiments of the present disclosure and do not represent all of the technical ideas, aspects, and features of the present disclosure. Accordingly, it should be understood that there may be various equivalents and modifications that can replace or modify the embodiments described herein at the time of filing this application.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of' and "any one of," when preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

References to two compared elements, features, etc. as being "the same" may mean that they are "substantially the same". Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

When an arbitrary element is referred to as being disposed (or located or positioned) on the "above (or below)" or "on (or under)" a component, it may mean that the arbitrary element is placed in contact with the upper (or lower) surface of the component and may also mean that another component may be interposed between the component and any arbitrary element disposed (or located or positioned) on (or under) the component.

In addition, it will be understood that when an element is referred to as being "coupled," "linked" or "connected" to another element, the elements may be directly "coupled," "linked" or "connected" to each other, or an intervening element may be present therebetween, through which the element may be "coupled," "linked" or "connected" to another element. In addition, when a part is referred to as being "electrically coupled" to another part, the part can be directly connected to another part or an intervening part may be present therebetween such that the part and another part are indirectly connected to each other.

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

FIG. 1 is a schematic block diagram of a battery state-of-charge estimation system according to one embodiment of the present invention.

Referring to FIG. 1, a battery state-of-charge (SOC) estimation system according to one embodiment of the present invention includes a battery rack 100, a sensor 200, and a battery state-of-charge estimation apparatus 300.

The battery rack 100 may include multiple battery cells arranged in series to form a single package. The battery rack 100 may include first to $n^{th}$ battery cells arranged in series. Although this embodiment will be described with multiple battery cells connected to each other in series, it should be understood that the present invention is not limited thereto and may be applied to battery cells connected in series and/or in parallel.

The battery cells may include lithium-ion cells, lithium polymer cells, nickelcadmium cells, nickel-hydrogen cells, nickel-zinc cells, and the like, which can be repeatedly charged and discharged, without being limited thereto.

While the multiple cells constituting the battery rack 100 are charged/discharged, the sensor 200 may measure a current and voltage of each of the cells at predetermined periodic intervals and may transmit the measured data of each of the cells to the battery state-of-charge estimation apparatus 300. The measurement data may include the current, voltage, and the like of each cell.

Such a sensor 200 may include a voltage sensor (not shown) and a current sensor (not shown) to measure voltage and current of each cell and may measure the current and voltage of each cell under charging/discharging conditions at predetermined periodic intervals.

The battery state-of-charge estimation apparatus 300 may calculate a representative SOC of the battery rack 100 based on the measurement data of each of the cells measured by the sensor 200. The representative SOC of the battery rack 100 may be a parameter indicative of the state of charge of the battery rack 100 and may be a value representative of the SOC of the battery rack 100 including the cells.

The battery state-of-charge estimation apparatus 300 is a device for estimating the state of a battery and may be realized by a software module, a hardware module, or a combination thereof. For example, the battery state-of-charge estimation apparatus 300 may be realized by a battery management system (BMS). The BMS is a system that manages batteries, for example, by monitoring conditions of the batteries, maintaining optimized conditions under which the batteries operate, predicting when the batteries are required to replaced, detecting problems with the batteries, and generating control or instruction signals associated with the batteries to control the condition or operation of the batteries.

The battery state-of-charge estimation apparatus 300 will be described in detail with reference to FIG. 2.

FIG. 2 is a schematic block diagram of a battery state-of-charge estimation apparatus according to one embodiment of the present invention.

Referring to FIG. 2, the battery state-of-charge estimation apparatus 300 according to the embodiment of the present invention includes a memory 310 and a processor 320.

The memory 310 stores data related to operation of the battery state-of-charge estimation apparatus 300. In particular, the memory 310 may store an application (program or applet) or the like, which calculates a maximum SOC of a maximum-voltage cell and a minimum SOC of a minimum-voltage cell and calculates a representative SOC of the battery rack 100 based on the maximum SOC and the minimum SOC upon charging/discharging a battery rack 100 including multiple cells, in which data stored in the memory 310 may be selected by processor 320 as needed. In other words, the memory 310 stores various types of data generated during execution of an operating system or a control application (program or applet) for operation of the battery state-of-charge estimation apparatus 300. In addition, the memory 310 may store a first SOC upper limit and a first SOC lower limit corresponding to a battery operation range, measurement data of each cell, and the like. Such a memory 310 may include magnetic storage media or flash storage media in addition to volatile storage devices that require power to maintain the stored data, without being limited thereto.

Upon charging/discharging the battery rack 100 including the multiple cells, the processor 320 may calculate the maximum SOC of the maximum-voltage cell and the minimum SOC of the minimum-voltage cell, and may calculate the representative SOC of the battery rack 100 based on the maximum SOC and the minimum SOC.

Hereinafter, operation of the processor 320 will be described in detail.

The processor 320 may receive measurement data of each cell from the sensor 200 at regular intervals while the multiple cells included in the battery rack 100 are simultaneously charged/discharged. Here, the measurement data may include voltage and current of each cell.

When the measurement data of each cell is received, the processor 320 may calculate the maximum SOC of the maximum-voltage cell and the minimum SOC of the minimum-voltage cell. Here, the processor 320 may calculate the maximum SOC based on a voltage and current of the maximum-voltage cell having the highest voltage among voltages of the multiple cells. Further, the processor 320 may calculate the minimum SOC based on a voltage and current of the minimum-voltage cell having the lowest voltage among the voltages of the multiple cells. Since SOC is a parameter indicative of the state of charge and indicates how much energy is stored in a given cell, SOC may be expressed as a quantity from 0% to 100%. For example, 0% may mean a fully discharged state and 100% may mean a fully charged state.

However, it should be noted that this representation may be defined in various variations depending on a design intention or an embodiment.

Once the maximum SOC and the minimum SOC are calculated, the processor 320 may calculate an average SOC and a deviation SOC of the maximum SOC and the minimum SOC. Here, the processor 320 may calculate the average SOC according to Equation 1 below and the deviation SOC according to Equation 2.

[Equation 1]

Average SOC = (Maximum SOC + Minimum SOC) /2

[Equation 2]

Deviation SOC = Maximum SOC - Minimum SOC

Then, the processor 320 may apply the deviation SOC to the first SOC upper limit and the first SOC lower limit, which correspond to the battery operation range, to calculate a second SOC upper limit and a second SOC lower limit. Here, the first SOC upper limit and the first SOC lower limit corresponding to the battery operation range may refer to a preset operating limit range. The processor 320 may calculate the second SOC upper limit by subtracting a preset ratio of the deviation SOC from the first SOC upper limit and may calculate the second SOC lower limit by adding the preset ratio of the deviation SOC to the first SOC lower limit. For example, the processor 320 may subtract or add ½ of the deviation SOC with respect to the first SOC upper limit and the first SOC lower limit, which correspond to the battery operation range, to calculate the second SOC upper limit and the second SOC lower limit. That is, the processor 320 may calculate the second SOC upper limit and the second SOC lower limit according to Equations 3 and 4, respectively.

[Equation 3]

Second SOC upper limit = First SOC upper limit - (deviation SOC/2)

[Equation 4]

Second SOC lower limit = First SOC lower limit + (deviation SOC/2)

Once the second SOC upper limit and the second SOC lower limit are calculated, the processor 320 may calculate a first weight of the maximum SOC and a second weight of the minimum SOC based on the second SOC upper limit, the second SOC lower limit, and the average SOC, respectively. Here, the processor 320 may subtract the average SOC from the second SOC upper limit and the second SOC lower limit to calculate the second weight of the minimum SOC and the first weight of the maximum SOC, respectively. That is, the processor 320 may calculate the second weight and the first weight according to Equations 5 and 6, respectively.

Secondary weight = (Second SOC upper limit - Average SOC)/(Second SOC upper limit - Second SOC lower limit) [equation 5]

saisir math texte [equation 6]

Once the first weight and the second weight are calculated, the processor 320 may apply the first weight and the second weight to the maximum SOC and the minimum SOC to calculate a representative SOC of the battery rack 100. Here, the processor 320 may calculate the representative SOC of the battery rack 100 according to Equation 7.

Representative SOC = First weight*maximum SOC + Second weight*minimum SOC [equation 7]

Such a processor 320 has a configuration that controls the overall operation of the battery state-of-charge estimation apparatus 300 and may be realized by an integrated circuit, a system-on-chip, or a mobile AP.

The processor 320 may control the overall operation of the battery state-of-charge estimation apparatus 300. The processor 320 may refer to a data processing device embedded in hardware and having, for example, a physically structured circuit to perform functions expressed by code or instructions contained within a program. Examples of the hardware-embedded data processing device may include a microprocessor, a central processing unit (CPU), a processor core, a multiprocessor, an application-specific integrated circuit (ASIC), a field programmable gate array (FPGA), and the like, without being limited thereto.

FIG. 3 is a flow diagram illustrating a method of calculating a representative SOC of a battery rack according to one embodiment of the present invention and FIG. 4 is a graph comparing the representative SOC calculation method according to the embodiment of the invention with a typical SOC calculation method.

Referring to FIG. 3, while multiple cells included in a battery rack 100 are simultaneously charged/discharged (S302), the processor 320 receives measurement data of each cell from the sensor 200 at regular intervals (S304). The measurement data may include a voltage and current of each cell.

After step S304 is performed, the processor 320 calculates a maximum SOC of a maximum-voltage cell and a minimum SOC of a minimum-voltage cell based on the measurement data of each cell (S306). Here, the processor 320 may calculate the maximum SOC based on a voltage and current of the maximum-voltage cell having the highest voltage among voltages of the multiple cells. Further, the processor 320 may calculate the minimum SOC based on a voltage and current of the minimum-voltage cell having the lowest voltage among the voltages of the multiple cells.

After step S306 is performed, the processor 320 calculates an average SOC and a deviation SOC of the maximum SOC and the minimum SOC (S308). Here, the processor 320 may calculate an average of the maximum SOC and the minimum SOC as the average SOC. Further, the processor 320 may calculate a difference between the maximum SOC and the minimum SOC as the deviation SOC.

After step S308 is performed, the processor 320 applies the deviation SOC to a first SOC upper limit and a first SOC lower limit, which correspond to a battery operation range, to calculate a second SOC upper limit and a second SOC lower limit (S310). Here, the processor 320 may subtract ½ of the deviation SOC from the first SOC upper limit, which corresponds to the battery operation range, to calculate the second SOC upper limit. Further, the processor 320 may add ½ of the deviation SOC to the first SOC lower limit, which corresponds to the battery operation range, to calculate the second SOC lower limit.

After step S310 is performed, the processor 320 calculates a first weight of the maximum SOC and a second weight of the minimum SOC based on the second SOC upper limit, the second SOC lower limit, and the average SOC, respectively (S312). Here, the processor 320 may calculate the second weight by dividing a value obtained through subtraction of the average SOC from the second SOC upper limit by a value obtained through subtraction of the second SOC lower limit from the second SOC upper limit. Further, the processor 320 may calculate the first weight by subtracting the second weight from 1.

After step S312 is performed, the processor 320 applies the first weight and the second weight to the maximum SOC and the minimum SOC to calculate a representative SOC of the battery rack 100 (S314). Here, the processor 320 may calculate the representative SOC by adding a value obtained by multiplying the maximum SOC by the first weight to a value obtained by multiplying the minimum SOC by the second weight.

For example, when the first SOC upper limit is 100%, the first SOC lower limit is 0%, the maximum SOC of the maximum-voltage cell is 90%, and the minimum SOC of the minimum-voltage cell is 70%, the representative SOC may be calculated by the following method.

First, the processor 320 may calculate an average SOC 80%, which is an average of the maximum SOC 90% and the minimum SOC 70%, and a deviation SOC 20%, which is a difference between the maximum SOC 90% and the minimum SOC 70%.

Then, the processor 320 may subtract ½ of the deviation SOC 20% from the first SOC upper limit 100% (100% - (20%/2)) to obtain a second upper limit 90% and may add ½ of the deviation SOC 20% to the first SOC lower limit 0% (0% + (20%/2)) to obtain a second lower limit 10%.

Then, the processor 320 may calculate (second SOC upper limit 90% - average SOC 80%)/(second SOC upper limit 90% - second SOC lower limit 10%) = 0.125 as the second weight, and (1 - second weight 0.125) = 0.875 as the first weight.

Next, the processor 320 may calculate ((first weight 0.875 *maximum SOC 90%) + (second weight 0.125 *minimum SOC 70%)) = 87.5% as the representative SOC.

As described above, the apparatus and method according to the present invention can protect batteries from a risk of overcharging/overdischarging by calculating a representative SOC of the battery rack 100 based on the maximum SOC of the highest voltage cell and the minimum SOC of the lowest voltage cell upon charging/discharging the battery rack 100 including multiple cells. For example, referring to FIG. 4, at the time of a full charge (SOC 100%), the representative SOC of the battery rack 100 is 100% and there is no risk of overcharging. However, if the SOC is calculated based on an average voltage of all cells at the time of full charge (SOC 100%), there is a risk of overcharging the battery rack to an SOC of 105%.

A battery state-of-charge estimation apparatus and method according to the present invention calculates a representative SOC of a battery rack based on a maximum SOC of a maximum-voltage cell and a minimum SOC of a minimum-voltage cell upon charging/discharging the battery rack including multiple cells, thereby providing an effect of protecting batteries from overcharging/overdischarging while enabling calculation of the SOC with minimal resources.

Although the present invention has been described with reference to some example embodiments, it should be understood by those skilled in the art that these embodiments are given by way of illustration only, and that various modifications, variations and alterations can be made without departing from the scope of the invention. Therefore, the scope of the invention should be limited only by the accompanying claims and equivalents thereto.

Embodiments are set out in the following clauses:

Clause 1. A battery state-of-charge estimation apparatus, comprising: a memory; and a processor connected to the memory, wherein, upon charging/discharging a battery rack comprising multiple cells, the processor calculates a maximum state of charge (SOC) of a maximum-voltage cell and a minimum SOC of a minimum-voltage cell and calculates a representative SOC of the battery rack based on the maximum SOC and the minimum SOC.

Clause 2. The battery state-of-charge estimation apparatus according to clause 1, wherein, upon charging/discharging the battery rack, the processor calculates the maximum SOC based on a voltage and current of the maximum-voltage cell having the highest voltage among voltages of the multiple cells, and calculates the minimum SOC based on a voltage and current of the minimum-voltage cell having the lowest voltage among the voltages of the multiple cells.

Clause 3. The battery state-of-charge estimation apparatus according to clause 1, wherein the processor calculates a first weight of the maximum SOC and a second weight of the minimum SOC based on a battery operation range, an average SOC and a deviation SOC of the maximum SOC and the minimum SOC, and applies the first weight and the second weight to the maximum SOC and the minimum SOC to calculate the representative SOC, respectively.

Clause 4. The battery state-of-charge estimation apparatus according to clause 3, wherein the processor applies the deviation SOC to a first SOC upper limit and a first SOC lower limit corresponding to the battery operation range to calculate a second SOC upper limit and a second SOC lower limit, and calculates the first weight of the maximum SOC and the second weight of the minimum SOC based on the second SOC upper limit, the second SOC lower limit, and the average SOC.

Clause 5. The battery state-of-charge estimation apparatus according to clause 4, wherein the processor subtracts a preset ratio of the deviation SOC from the first SOC upper limit to calculate the second SOC upper limit and adds the preset ratio of the deviation SOC to the first SOC lower limit to calculate the second SOC lower limit.

Clause 6. The battery state-of-charge estimation apparatus according to clause 4, wherein the processor calculates the second weight by dividing a value obtained through subtraction of the average SOC from the second SOC upper limit by a value obtained through subtraction of the second SOC lower limit from the second SOC upper limit, and calculates the first weight by subtracting the second weight from 1.

Clause 7. A battery state-of-charge estimation method comprising: upon charging/discharging a battery rack comprising multiple cells: receiving, by a processor, measurement data of each of the cells from a sensor; calculating, by the processor, a maximum SOC of a maximum-voltage cell and a minimum SOC of a minimum-voltage cell based on the measurement data of each of the cells; and calculating, by the processor, a representative SOC of the battery rack based on the maximum SOC and the minimum SOC.

Clause 8. The battery state-of-charge estimation method according to clause 7, wherein, in calculation of the maximum SOC of the maximum-voltage cell and the minimum SOC of the minimum-voltage cell, the processor calculates the maximum SOC based on a voltage and current of the maximum-voltage cell having the highest voltage among voltages of the multiple cells, and the minimum SOC based on a voltage and current of the minimum-voltage cell having the lowest voltage among the voltages of the multiple cells.

Clause 9. The battery state-of-charge estimation method according to clause 7, wherein the step of calculating a representative SOC of the battery rack comprises: calculating, by the processor, an average SOC and a deviation SOC of the maximum SOC and the minimum SOC; applying, by the processor, the deviation SOC to a first SOC upper limit and a first SOC lower limit corresponding to a battery operating range to calculate a second SOC upper limit and a second SOC lower limit; calculating, by the processor, a first weight of the maximum SOC and a second weight of the minimum SOC based on the second SOC upper limit, the second SOC lower limit, and the average SOC; and applying, by the processor, the first weight and the second weight to the maximum SOC and the minimum SOC to calculate the representative SOC of the battery rack.

Clause 10. The battery state-of-charge estimation method according to clause 9, wherein, in calculation of the second SOC lower limit, the processor subtract a preset ratio of the deviation SOC from the first SOC upper limit to calculate the second SOC upper limit and adds the preset ratio of the deviation SOC to the first SOC lower limit to calculate the second SOC lower limit.

Clause 11. The battery state-of-charge estimation method according to clause 9, wherein, in calculation of the second weight, the processor calculates the second weight by dividing a value obtained through subtraction of the average SOC from the second SOC upper limit by a value obtained through subtraction of the second SOC lower limit from the second SOC upper limit and calculates the first weight by subtracting the second weight from 1.

**Claims**

1. A battery state-of-charge estimation apparatus, comprising:

   a memory; and
   a processor connected to the memory,
   wherein, upon charging/discharging a battery rack comprising multiple battery cells, the processor calculates a maximum state of charge (SOC) of a maximum-voltage cell and a minimum SOC of a minimum-voltage cell and calculates a representative SOC of the battery rack based on the maximum SOC and the minimum SOC.

2. The battery state-of-charge estimation apparatus according to claim 1, wherein, upon charging/discharging the battery rack, the processor calculates the maximum SOC based on a voltage and current of the maximum-voltage cell having a highest voltage among voltages of the multiple battery cells, and calculates the minimum SOC based on a voltage and current of the minimum-voltage cell having a lowest voltage among the voltages of the multiple battery cells.

3. The battery state-of-charge estimation apparatus according to claim 1 or 2, wherein the processor calculates a first weight of the maximum SOC and a second weight of the minimum SOC based on a battery operation range, an average SOC and a deviation SOC of the maximum SOC and the minimum SOC, and applies the first weight and the second weight to the maximum SOC and the minimum SOC, respectively, to calculate the representative SOC.

4. The battery state-of-charge estimation apparatus according to claim 3, wherein the processor applies the deviation SOC to a first SOC upper limit and a first SOC lower limit corresponding to the battery operation range to calculate a second SOC upper limit and a second SOC lower limit, and calculates the first weight of the maximum SOC and the second weight of the minimum SOC based on the second SOC upper limit, the second SOC lower limit, and the average SOC.

5. The battery state-of-charge estimation apparatus according to claim 4, wherein the processor subtracts a preset ratio of the deviation SOC from the first SOC upper limit to calculate the second SOC upper limit and adds the preset ratio of the deviation SOC to the first SOC lower limit to calculate the second SOC lower limit.

6. The battery state-of-charge estimation apparatus according to claim 4 or 5, wherein the processor calculates the second weight by dividing a value obtained through subtraction of the average SOC from the second SOC upper limit by a value obtained through subtraction of the second SOC lower limit from the second SOC upper limit, and calculates the first weight by subtracting the second weight from 1.

7. A battery state-of-charge estimation method comprising, upon charging/discharging a battery rack comprising multiple battery cells:

   receiving, by a processor, measurement data of each of the battery cells from a sensor;
   calculating, by the processor, a maximum SOC of a maximum-voltage cell and a minimum SOC of a minimum-voltage cell based on the measurement data of each of the battery cells; and
   calculating, by the processor, a representative SOC of the battery rack based on the maximum SOC and the minimum SOC.

8. The battery state-of-charge estimation method according to claim 7, wherein, in calculating the maximum SOC of the maximum-voltage cell and the minimum SOC of the minimum-voltage cell, the processor calculates the maximum SOC based on a voltage and current of the maximum-voltage cell having a highest voltage among voltages of the multiple battery cells, and the minimum SOC based on a voltage and current of the minimum-voltage cell having a lowest voltage among the voltages of the multiple battery cells.

9. The battery state-of-charge estimation method according to claim 7 or 8, wherein calculating the representative SOC of the battery rack comprises:

   calculating, by the processor, an average SOC and a deviation SOC of the maximum SOC and the minimum SOC;
   applying, by the processor, the deviation SOC to a first SOC upper limit and a first SOC lower limit corresponding to a battery operating range to calculate a second SOC upper limit and a second SOC lower limit;
   calculating, by the processor, a first weight of the maximum SOC and a second weight of the minimum SOC based on the second SOC upper limit, the second SOC lower limit, and the average SOC; and
applying, by the processor, the first weight and the second weight to the maximum SOC and the minimum SOC, respectively, to calculate the representative SOC of the battery rack.

**10.** The battery state-of-charge estimation method according to claim 9, wherein, in calculating the second SOC lower limit, the processor subtracts a preset ratio of the deviation SOC from the first SOC upper limit to calculate the second SOC upper limit and adds the preset ratio of the deviation SOC to the first SOC lower limit to calculate the second SOC lower limit.

**11.** The battery state-of-charge estimation method according to claim 9 or 10, wherein, in calculating the second weight, the processor calculates the second weight by dividing a value obtained through subtraction of the average SOC from the second SOC upper limit by a value obtained through subtraction of the second SOC lower limit from the second SOC upper limit and calculates the first weight by subtracting the second weight from 1.

FIG. 1

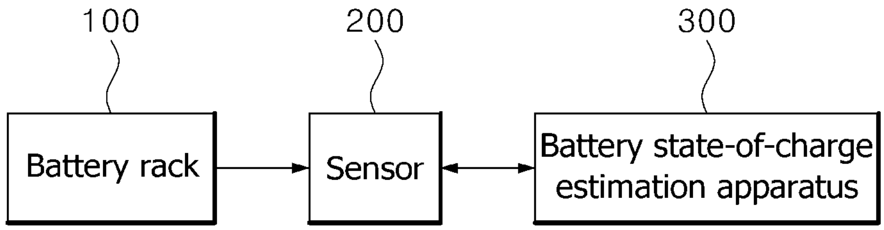
100
200
300
Battery rack
Sensor
Battery state-of-charge estimation apparatus

FIG. 2

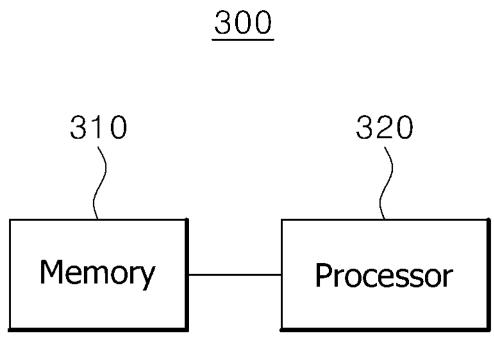
300
310
320
Memory
Processor

FIG. 3

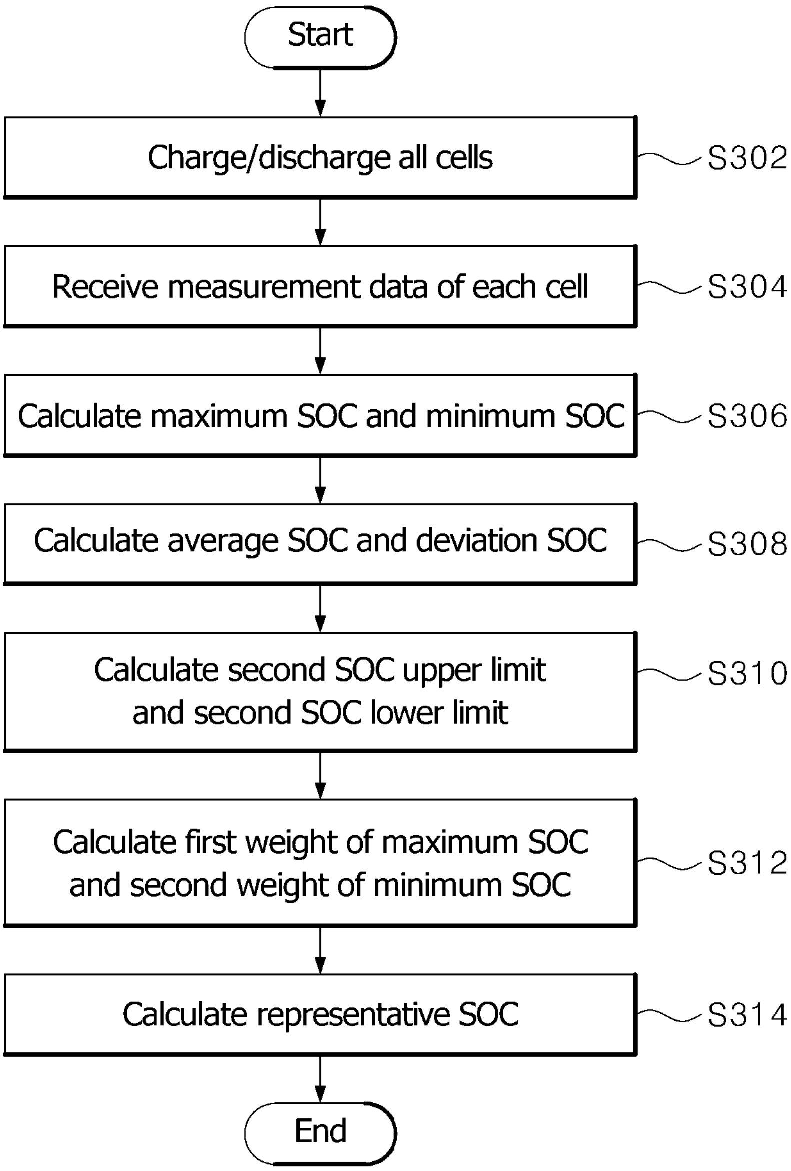
Start
Charge/discharge all cells
S302
Receive measurement data of each cell
S304
Calculate maximum SOC and minimum SOC
S306
Calculate average SOC and deviation SOC
S308
Calculate second SOC upper limit and second SOC lower limit
S310
Calculate first weight of maximum SOC and second weight of minimum SOC
S312
Calculate representative SOC
S314
End

FIG. 4

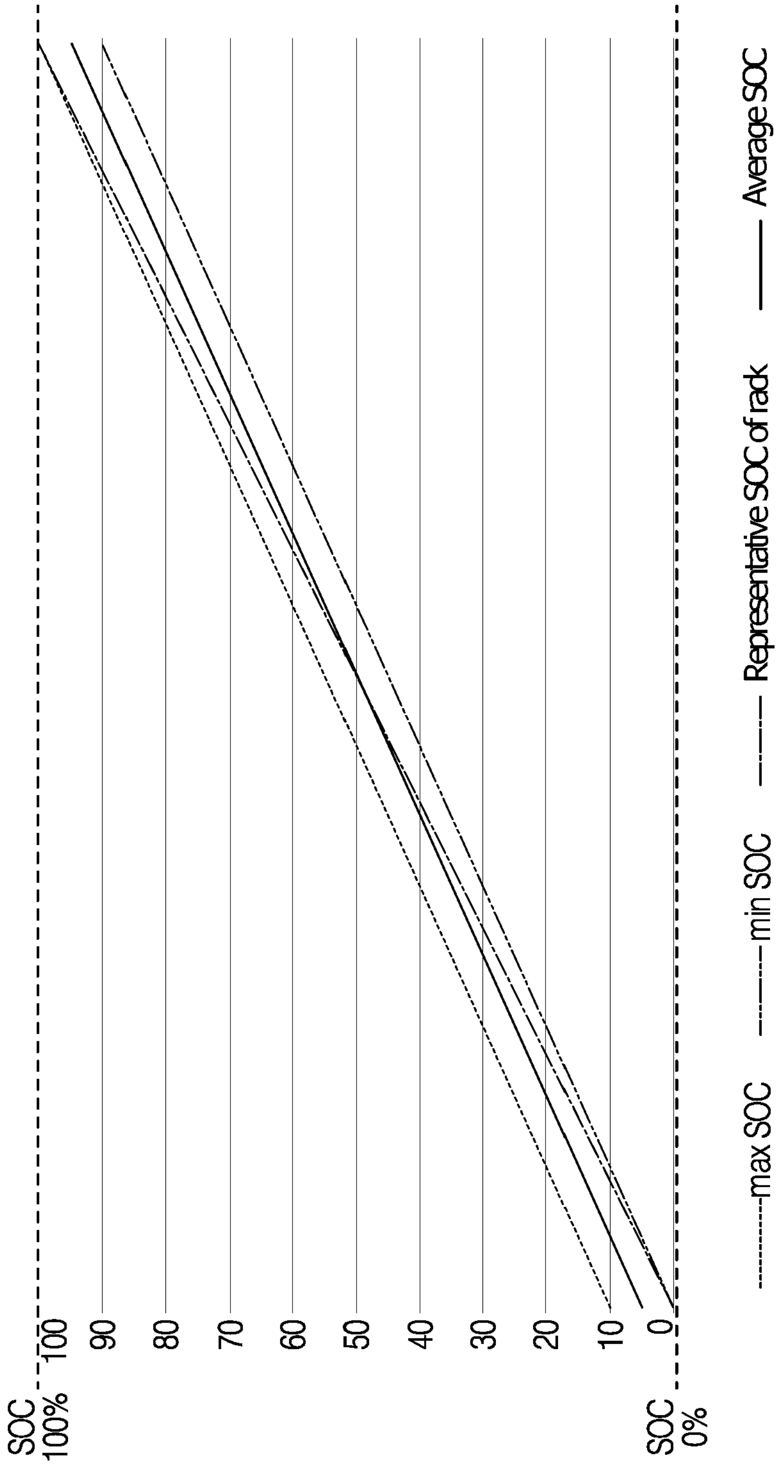
SOC 100%
SOC 0%
100
90
80
70
60
50
40
30
20
10
0
max SOC
min SOC
Representative SOC of rack
Average SOC

Europäisches Patentamt
European Patent Office
Office européen des brevets

# EUROPEAN SEARCH REPORT

Application Number
EP 24 16 4760

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2018/143258 A1 (KIM SUNGICK [KR] ET AL) 24 May 2018 (2018-05-24) | 1-3,7,8 | INV. B60L58/12 G01R31/367 G01R31/3835 G01R31/3842 G01R31/396 H01M10/48 H02J7/00 |
| A | * paragraphs [0042], [0046], [0053] - [0063], [0069], [0070] - [0078]; figures 2A,2B,6 * | 4-6,9-11 | |
| X | US 2021/188121 A1 (KIKUCHI YOSHIAKI [JP] ET AL) 24 June 2021 (2021-06-24) | 1,2,7,8 | |
| A | * paragraphs [0037], [0045], [0050], [0096]; figures 1-10 * | 3-6,9-11 | |
| A | WO 2010/140235 A1 (MITSUBISHI HEAVY IND LTD [JP]; KYUSHU ELECTRIC POWER [JP] ET AL.) 9 December 2010 (2010-12-09) * the whole document * | 1-11 | |
| A | US 2012/330503 A1 (BOEHM ANDRE [DE]) 27 December 2012 (2012-12-27) * claims 1-9; figures 1,2,4 * | 1-11 | |
| | | | TECHNICAL FIELDS SEARCHED (IPC) |
| | | | B60L G01R H02J H01M |

The present search report has been drawn up for all claims

2

| Place of search | Date of completion of the search | Examiner |
|---|---|---|
| The Hague | 28 October 2024 | Rambaud, Dilek |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

# ANNEX TO THE EUROPEAN SEARCH REPORT ON EUROPEAN PATENT APPLICATION NO. EP 24 16 4760

This annex lists the patent family members relating to the patent documents cited in the above-mentioned European search report.
The members are as contained in the European Patent Office EDP file on
The European Patent Office is in no way liable for these particulars which are merely given for the purpose of information.

28-10-2024

| Patent document cited in search report | Publication date | Patent family member(s) | Publication date |
|---|---|---|---|
| US 2018143258 A1 | 24-05-2018 | KR 20180058085 A | 31-05-2018 |
| | | US 2018143258 A1 | 24-05-2018 |
| US 2021188121 A1 | 24-06-2021 | CN 113002355 A | 22-06-2021 |
| | | DE 102020130547 A1 | 24-06-2021 |
| | | JP 7184028 B2 | 06-12-2022 |
| | | JP 2021097573 A | 24-06-2021 |
| | | US 2021188121 A1 | 24-06-2021 |
| WO 2010140235 A1 | 09-12-2010 | NONE | |
| US 2012330503 A1 | 27-12-2012 | CN 102656470 A | 05-09-2012 |
| | | DE 102009054924 A1 | 22-06-2011 |
| | | EP 2513659 A2 | 24-10-2012 |
| | | JP 6013188 B2 | 25-10-2016 |
| | | JP 2013513809 A | 22-04-2013 |
| | | US 2012330503 A1 | 27-12-2012 |
| | | WO 2011079977 A2 | 07-07-2011 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- KR 101467363